# EUROPÄISCHE PATENTSCHRIFT

(11) **EP 1 622 196 B1**
(45) Veröffentlichungstag und Bekanntmachung des Hinweises auf die Patenterteilung: **30.08.2006**
(21) Anmeldenummer: 04018148.9
(22) Anmeldetag: 30.07.2004
(51) Int. Cl.: H01L 21/68, B23Q 17/24, G05D 3/12

(54) **Waferbearbeitungsvorrichtung und zugehöriges Verfahren**
Apparatus for treating a wafer and a method therefor
Un appareil pour traiter un wafer et un procédé appartenant

(43) Veröffentlichungstag der Anmeldung: 01.02.2006
(73) Patentinhaber: Innolas GmbH, 82152 Krailling (DE)
(72) Erfinder: Behr, Andreas, 86899 Landsberg (DE)
(74) Vertreter: Seitz, Ralf Hans Frank

(56) Entgegenhaltungen:
- EP-A- 0 278 462
- US-A- 4 461 567
- US-A- 5 308 222
- US-A1- 2002 070 095

## Beschreibung

Die Erfindung betrifft eine Vorrichtung zum Makieren eines Wafers und ein zugehöriges Verfahren.

In der WO 02/079059 ist eine bekannte Ausrichtvorrichtung, auch Prealigner genannt, zum Ausrichten eines Wafers beschrieben, die einen Teller, auf dem der Wafer mit seinem Zentrum beim Ausrichten flächig aufliegt und der elektromotorisch zum Ausrichten des Wafers gedreht werden kann, und eine Detektionseinrichtung mit einer CCD-Kamera und einer zugehörigen Lichtquelle zum Detektieren einer Randkerbe bzw. Notch des Wafers hat.

In der US 5,308,222 ist eine Waferbearbeitungsvorrichtung, z.B. eine Laserschreib- und Markiervorrichtung zum Ausbilden von Barcodesymbolen oder alphanummerischen Zeichen auf Wafern, beschrieben, die einen nicht zentrierenden Prealigner hat, der eine Rotationsstufe, auf der der Wafer mit seinem Mittenbereich großflächig aufliegt, mittels Vakuumansaugung gehalten und gedreht wird, und eine X-Y-Stufe hat, mittels der der Wafer in eine Ist-Bearbeitungsposition bewegt wird.

Die US 4,461,567 beschreibt ein Verfahren und eine Vorrichtung zum Belichten eines Wafers in einer Belichtungsstation, wobei eine Grobausrichtung eines Wafers in einer Grobausrichtungsstufe ausgeführt wird und eine Feinausrichtung des Wafers in der Belichtungsstufe selbst ausgeführt wird. Die Grobausrichtstufe hat einen Drehteller mit einer zentralen Ansaugung und eine XY-Verfahrstufe. Die Bearbeitung bzw. die Belichtung des Wafers erfolgt erst nach der Feinausrichtung des Wafers.

In dem Dokument US 2002/0070095 A1 ist eine Substratausrichtvorrichtung beschrieben, die die Kerben von fünf horizontalen Wafern detektiert und ausrichtet. Die Wafer werden nur an ihren Rändern bzw. Randbereichen an schrägen Flächen der Vorrichtung abgestützt oder getragen. Als Bearbeitungsstation für einen Wafer wird eine CVD-Vorrichtung erwähnt.

Nach dem Ausrichten des Wafers im Aligner ist der Wafer in einer Bearbeitungsposition, in der eine Bearbeitung des Wafers durch eine Bearbeitungsvorrichtung erfolgt. Da die vom Wafer eingenommene Bearbeitungsposition im allgemeinen aufgrund von nicht auszuschließenden Fertigungstoleranzen der Ausrichtvorrichtung und auch des Wafers nicht einer vorgesehenen oder vorgegebenen Bearbeitungsposition entspricht, entstehen bei der Bearbeitung bzw. Markieren entsprechende Fehler oder Ungenauigkeiten, die nicht erwünscht sind.

Aufgabe der Erfindung ist es deshalb, eine Markier vorrichtung anzugeben, die diese Ausrichtfehler beim Markieren des zu bearbeitenden Wafers korrigieren kann.

Diese Aufgabe wird durch die Markiervorrichtung nach Anspruch 1 bzw. durch das Verfahren nach Anspruch 12 gelöst.

Demnach hat die Markiervorrichtung der Erfindung zum Markieren oder Beschreiben eines Wafers mit einem Laserstrahl eine Ausrichtvorrichtung mit einem Drehteller zum Ausrichten eines Wafers, der den Wafer trägt und der um seine Drehachse zum Ausrichten des Wafers in eine Ist-Bearbeitungsposition drehbar ist, und eine Lasereinrichtung, die den Laserstrahl erzeugt, den eine Laserstrahlablenkeinheit und eine Fokussiereinrichtung der Lasereinrichtung auf die Waferoberfläche lenkt, um den Wafer an einer vorgesehenen Stelle zu markieren oder zu beschreiben, wobei der Drehteller derart ausgebildet ist, dass der Wafer auf dem Drehteller nur mit seinem Rand oder Randbereich aufliegt, wobei eine Versatzdetektionseinrichtung vorgesehen ist, die einen Versatz oder Zugehörige Versatzkoordinaten als ein Maß für einen Ausrichtfehler zwischen einer Soll-Bearbeitungsposition, in der ein Wafer von der Lasereinrichtung markiert werden soll, und der tatsächlich durch die Ausrichtvorrichtung erreichten Ist-Bearbeitungsposition des zu markierenden Wafers mittels mindestens einer Kameraeinrichtung zum Aufnehmen eines Bilds oder Teilbilds eines Wafers ermittelt, und wobei die Laserstrahlablenkeinheit den ermittelten Versatz oder die zugehörigen Versatzkoordinaten zum Korrigieren oder Kompensieren des Ausrichtfehlers beim Markieren oder Beschreiben des Wafers verwendet.

Der Versatz wird von der Markiervorrichtung zur Korrektur eines Ausrichtfehlers in der Ausrichtvorrichtung bei der Waferbearbeitung verwendet, wodurch die Genauigkeit der Wafermarkierung erheblich erhöht werden kann.

Die Markiervorrichtung hat eine Lasereinrichtung ,die einen Laserstrahl erzeugt, welcher über eine Laserstrahlablenkeinheit und eine Fokussiereinrichtung auf die Waferoberfläche gelenkt wird, um den Wafer an einer vorgesehenen Stelle zu markieren oder zu beschreiben. Die Laserstrahlablenkeinheit berücksichtigt den ermittelten Versatz oder zugehörige Versatzkoordinaten zum Korrigieren oder Kompensieren eines Ausrichtfehlers des Wafers in der Ausrichtvorrichtung.

Die Erfindung betrifft auch ein Verfahren zum Markieren oder Beschreiben eines Wafers mit einem Laserstrahl, bei dem der Wafer von einem Drehteller einer Ausrichtvorrichtung getragen wird und der Wafer auf dem Drehteller zum Ausrichten des Wafers in eine Ist-Bearbeitungsposition um eine Drehachse des Drehtellers gedreht wird, wobei der Wafer von dem Drehteller nur an einem Rand oder Randbereich des Wafers getragen wird, wobei mit einer Kameraeinrichtung einer Versatzdetektionseinrichtung von einem auf einem Drehteller der Ausrichtvorrichtung aufliegenden Musterwafer oder Referenzwafer, der genau in einer vorgegebenen Soll-Bearbeitungsposition angeordnet worden ist, ein digitales Referenzbild als Soll-Bild aufgenommen wird, das in einem entsprechenden Soll-Bildspeicher abgespeichert wird, wobei vor der tatsächlichen Bearbeitung eines zu markierenden oder zu beschreibenden Wafers, der bereits in die Ist-Bearbeitungsposition auf dem Drehteller gedreht worden ist, von der Kameraeinrichtung der Versatzdetektionseinrichtung ein Ist-Bild des Wafers in der erreichten Ist-Bearbeitungsposition aufgenommen wird, wobei das Soll-Bild und das Ist-Bild von der Versatzdetektionseinrichtung miteinander verglichen werden, um einen Versatz oder zugehörige Versatzkoordinaten als ein Maß für einen Ausrichtfehler zwischen der Soll-Bearbeitungsposition, in der der Wafer bearbeitet werden soll, und der tatsächlichen Ist-Bearbeitungsposition des Wafers in der Ausrichtvorrichtung zu ermitteln und wobei der ermittelte Versatz oder die zugehörigen Versatzkoordinaten von einer Laserablenkeinheit zum Korrigieren oder Kompensieren des Ausrichtfehlers des Wafers beim Markieren oder beschreiben des Wafers mittels Laserstrahl verwendet wird oder werden.

Weitere vorteilhafte Weiterbildungen der Erfindung sind den Unteransprüchen zu entnehmen.

Weitere Vorteile, Anwendungsmöglichkeiten und vorteilhafte Weiterbildungen der Erfindung sind der nachfolgenden, detaillierten Beschreibung bevorzugter und beispielhafter Ausführungsformen der Erfindung in Verbindung mit den Zeichnungen zu entnehmen. Es zeigen:
- Fig. 1: eine perspektivische, schematische Teilansicht einer Ausführungsform der Bearbeitungsvorrichtung der Erfindung mit einem auf einer Ausrichtvorrichtung liegenden Wafer;
- Fig. 2: eine seitliche Ansicht der Vorrichtung von Fig. 1 in Richtung des Pfeils II in Fig. 1 gesehen;
- Fig. 3: eine seitliche Ansicht der Vorrichtung von Fig. 1 in Richtung des Pfeils III in Fig. 2 gesehen;
- Fig. 4: eine Draufsicht auf die Vorrichtung von Fig. 1 in Richtung des Pfeils IV in Fig. 3 gesehen;
- Fig. 5: eine perspektivische, herausgelöste Detailansicht einer Hebeeinrichtung von Fig.l;und
- Fig. 6: eine perspektivische, herausgelöste Ansicht des in der Ausführungsform der Erfindung von Fig. 1 verwendeten Drehtellers;

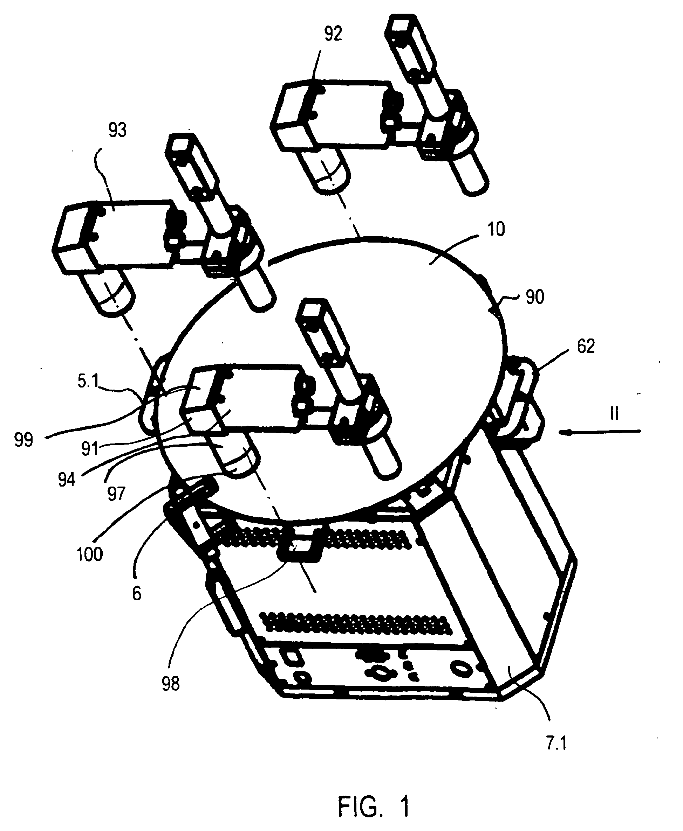

In der Fig.1 ist eine Teilansicht einer bevorzugten Ausführungsform der Bearbeitungsvorrichtung der Erfindung mit einer Ausrichtvorrichtung 40 zum Ausrichten eines zu bearbeitenden Wafers 10 in eine Bearbeitungsposition und mit einer Versatzdetektionseinrichtung 9 gezeigt.

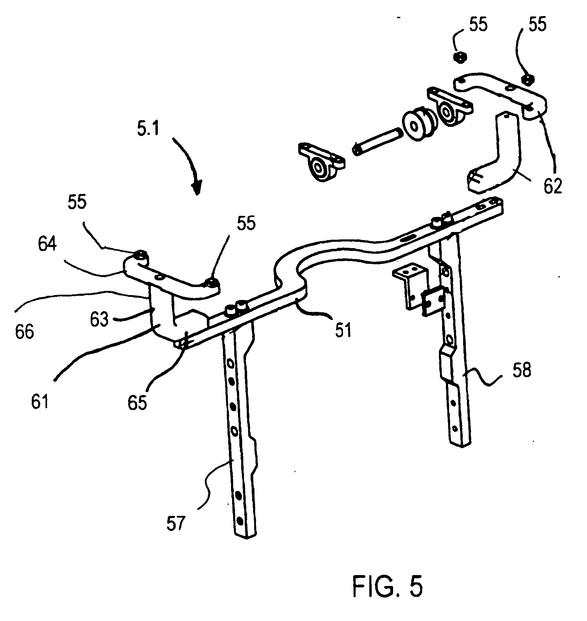

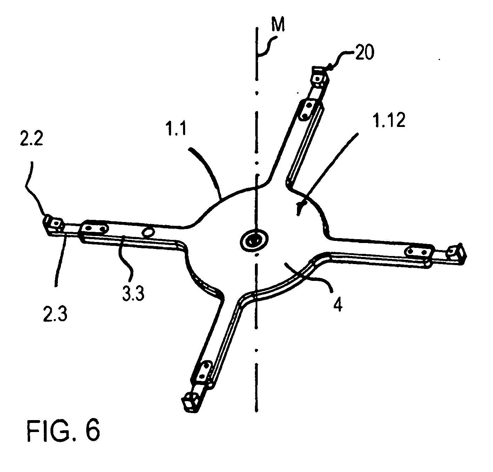

Die in Fig. 1 gezeigte, beispielhafte Ausrichtvorrichtung 40 der Erfindung hat im wesentlichen einen Drehteller 1.1 (vgl. Fig.6), eine Hebeeinrichtung 5.1 (vgl. Fig. 5), eine Detektionseinrichtung 6 und ein Gehäuse 7.1, in und an dem die Einrichtungen angeordnet und gehaltert sind.

Der Drehteller 1.1, hier z.B. aus Aluminium, weist eine zentrale, kreisförmige Scheibe 4 und mehrere relativ schmale Stege 3.3 bzw. Arme auf, die sich von der kreisförmigen Scheibe 4 des Drehtellers 1 radial nach außen erstrecken und an ihren freien Enden auflagerlos sind, also als Ausleger ausgelegt sind. Der in Fig. 6 gezeigte Drehteller 1.1 hat insgesamt vier, gleichlange Stege 3.3, wobei ein Winkel zwischen jeweils zweie, benachbarten Stegen 3.3 genau 90° beträgt. Jeder Steg 3.3 hat an seinem freien Ende ein Auflageteil 2.2, auf dem ein auszurichtender bzw. zu bearbeitender Wafer aufliegt. Genauer liegt der kreisrunde, scheibenförmige Wafer oder Siliziumwafer ausschließlich mit seinem Rand oder seinem Randbereich auf den vier Auflageteilen 2.2 der zugehörigen Stege 3.3 des Drehtellers 1.1 auf und kommt folglich nicht mit den sonstigen Oberflächen der Stege 3.3 oder der zentralen Scheibe 4 des Drehtellers 1.1 in Berührung.

Genauer gesehen hat jedes Auflageteil 2.2 eine gegenüber der Waagrechten geneigte Fläche 20, die wiederum in eine obere, ebene Fläche, eine daran anschließende mittlere, steiler geneigte Fläche und eine diese fortsetzende, untere, geneigte, ebene Fläche unterteilt ist. Die obere Fläche hat eine mittlere Neigung, bevorzugt einen Neigungswinkel von etwa 45°, gegenüber einer ebenen Oberseite 1.12 des Drehtellers 1, die der waagrechten oder horizontalen Ebene entspricht, welche eine Mittenachse M des Drehtellers 1.1 senkrecht schneidet. Die mittlere Fläche ist steiler, bevorzugt etwa 70 °, als die obere Fläche und hat die Funktion eines Anschlags für den Waferrand, wenn der Wafer seine waagrechte Lage auf den Auflageteilen 2 bzw. 2.2 des Drehtellers 1.1 eingenommen hat. Die untere Fläche hat dagegen eine geringere Neigung als die obere Fläche und die mittlere Fläche, und.zwar bevorzugt etwa 12,5°, gegenüber der waagrechten Ebene.

Die Neigung der Fläche 20 erstreckt sich von oben nach unten zu der waagrechten Drehtellerebene bzw. Oberseite 1.12 und zu der Drehachse M des Drehtellers 1 hin gesehen. Die Auflageteile 2.2 bestehen z.B. aus einem Polyaryletherketon, insbesondere Polyetheretherketon (PEEK). Die gesamte geneigte Fläche 20 ist poliert.

Der Drehteller 1.1 wird mit einem elektromotorischen Antrieb angetrieben, z.B. mit einem Schrittmotor oder bevorzugt einem **Gleichstromservomotor.** Eine Wegmesseinrichtung bzw. Drehwinkelmesseinrichtung (nicht gezeigt) ist vorgesehen, die den vom Drehteller 1.1 zurückgelegten Weg oder Drehwinkel ständig richtungsabhängig derart detektiert bzw. misst, dass die tatsächliche Position des Drehtellers 1 gegenüber einer Drehtellerreferenzposition oder Anfangsposition bekannt ist.

Wird ein Schrittmotor für den Drehantrieb des Drehtellers 1.1 verwendet, summiert oder subtrahiert die Wegmesseinrichtung die Ansteuerimpulse des Schrittmotors ausgehend von der Drehtellerreferenzposition richtungsabhängig in einem elektronischen Zähler oder Register, wobei der Zählerstand ein Maß für den zurückgelegten Drehweg bzw. die momentane Position des Drehtellers gegenüber der Drehtellerreferenzposition ist. Wird ein Servomotor eingesetzt, führt die Wegmesseinrichtung eine elektrooptische Inkrementalwinkelerfassung durch, die mit einer Strichscheibe oder einem Strichlineal bzw. einem Encoder arbeitet, um richtungsabhängige elektrische Impulse zu erzeugen, die wiederum in einem Zähler oder einem Register richtungsabhängig summiert oder subtrahiert werden, um die momentane Position des Drehtellers 1.1 angeben zu können.

Die Hebeeinrichtung 5.1 der Fig. 1 weist einen Querträger 51, der mit seinen auflagerlosen, freien Enden aus dem Gehäuse 7.1 durch entsprechende Längsschlitze nach außen heraussteht. Der Querträger 51 erstreckt sich senkrecht zur Drehachse M des Drehtellers 1.1 zum großen Teil im Inneren des Gehäuses 7.1.

Die Hebeeinrichtung 5.1 ist allgemein wiederum derart ausgebildet, dass beim Aufnehmen eines Wafers von dem Drehteller 1.1 aus der Wafer 10 ausschließlich mit seinem Rand bzw. Randbereich auf der Hebeeinrichtung 5.1 aufliegt. Die Hebeeinrichtung 5.1 hat hierfür mindestens zwei sich gegenüberliegende, konische oder geneigte Flächen, zwischen denen und auf denen ein aufgenommener Wafer ausschließlich mit seinem Rand bzw. Randbereich aufliegt, wenn die Hebeeinrichtung 5.1 den Wafer 10 von dem Drehteller 1.1 aus aufnimmt. Diese konischen oder geneigten Aufnahmeflächen der Hebeeinrichtung 5.1 sind in der Ausführungsform der Erfindung von Fig. 5 durch an der Spitze abgerundete, konische, rotationssymmetrische Stifte 55 mit einer verbreiterten Basis realisiert, die kreisrund scheibenförmig ist und radial nach außen konisch abgeflacht ist.

Die geneigte Fläche des Stifts 55 hat eine obere, abgerundete Fläche, eine daran anschließende, mittlere, geneigte Umfangsfläche, die bevorzugt einen Neigungswinkel von 70 ° zur Waagrechten aufweist und als Anschlag für den Waferrand dient, wenn der Wafer 10 seine waagrechte Lage auf den Stiften 55 der Hebeeinrichtung 5.1 eingenommen hat, und die daran anschließende, konisch abflachende Fläche der Basis, die bevorzugt einen Neigungswinkel gegenüber der Waagrechten von 10 ° hat.

Die konischen Stifte 55 sind z.B. aus einem Polyaryletherketon, insbesondere Polyetheretherketon (PEEK), hergestellt und ihre Oberflächen sind bevorzugt poliert.

Um den Wafer vom Drehteller 1.1 beim Ausrichtvorgang abheben zu können, führt die Hebeeinrichtung 5.1 eine lineare Hubbewegung in Richtung parallel zur Drehachse M des Drehtellers 1.1 durch, die durch eine weitere Antriebseinrichtung, die mit der Hebeeinrichtung 5.1 gekoppelt ist, ausgeführt wird. Die Antriebseinrichtung (nicht gezeigt) kann hierzu einen Servomotor bzw. Gleichstrommotor haben, der über ein Getriebe, das eine Bremse hat, mit der Hebeeinrichtung 5.1 gekoppelt ist. Das Getriebe kann zum Beispiel einen senkrecht angeordneten Zahnriemen haben, der mit der Hebeeinrichtung 5.1 fest gekoppelt ist und sich zwischen einem Antriebszahnrad und einem Umlenkzahnrad erstreckt, wobei die Drehbewegung des Motors über das Antriebszahnrad auf den Zahnriemen übertragen wird, der dann die Hebeeinrichtung 5.1 nach oben oder nach unten linear bewegt.

Wie in Fig.5 genauer gezeigt ist, hat die Hebeinrichtung 5.1 senkrecht, d.h. parallel zur Drehtellerachse M, sich erstreckende Stäbe 57 und 58, die in jeweils zugehörige Führungen (nicht gezeigt) im Gehäuse 7.1 geführt sind, um eine gleichmäßige und verkantungsfreie Hubbewegung der Hebeeinrichtung 1.1 ermöglichen zu können.

Die in Fig. 5 gezeigte Hebeeinrichtung 5.1 hat Tragteile 61 und 62 an den freien Enden des Querteils 51. Die Tragteile 61 und 62 sind gegenüberliegend und haben jeweils ein Winkelteil 63, das mit einem Schenkel 65 an einem Ende oder Endabschnitt des Querteils 51 angebracht ist, und einen im Grundriss c-förmigen Querschenkel 64, der mittig an dem Ende des anderen Schenkels 66 des Winkelteils 63 angebracht ist. Die freien Enden des c-förmigen Querschenkels 64 befinden sich außerhalb des Gehäuses 7.1 und weisen dann zur Drehachse M des Drehtellers 1 hin. An jedem der freien Enden der beiden Querschenkel 64 der Tragteile 61 und 62 ist jeweils ein konischer Stift 55 angeordnet und befestigt, dessen abgerundete Spitze nach oben weist. Die c-Form des Querschenkels 64 hat den Vorteil, dass der Randbereich des Wafers 10 zwischen den konischen Stiften 55 und auch die Enden der Stege 3 mit den Auflageteilen 2.2 nicht mit dem Winkelteil 63 in Berührung kommen und dass das Winkelteil 63 außerhalb des Drehbereichs des Drehtellers 1.1 ist.

Der Abstand zwischen den konischen Stiften 55 auf dem Querschenkel 64 ist derart ausgelegt, dass der Wafer 10 von den Stiften 55 der beiden gegenüberliegenden Tragteile 61 und 62 sicher abgestützt wird, aber andererseits ein möglichst großer Korrekturwinkel zwischen den Stegen 3.3 ermöglicht wird.

Die Detektionseinrichtung 6 bzw. Kerbe-Detektionseinrichtung hat einen elektrooptischen Sender, z.B. eine Lumineszenzdiode oder Laserdiode, der elektromagnetische Strahlung, z.B. Licht, abstrahlt, und einen elektrooptischen Empfänger, z.B. eine Photodiode, die die von dem elektrooptischen Sender abgegebene Strahlung empfängt und ein entsprechendes elektrisches Detektionssignal erzeugt. Der Empfänger und der Sender stehen sich mit Abstand zueinander derart gegenüber, dass ein auf dem Drehteller 1.1 aufliegender Wafer in den Lichtstrahl zwischen Sender und Empfänger eingreift und nach dem Prinzip einer Lichtschranke unterbricht, wodurch dann keine Strahlung zum Empfänger gelangen kann, außer die Randkerbe 90 des Wafers 10 liegt gerade im Strahlengang der Detektionseinrichtung 6, was gleichbedeutend damit ist, dass der Strahl vom Sender zum Empfänger nicht unterbrochen wird sondern zum Empfänger gelangt, wodurch ein entsprechendes Detektionssignal vom Empfänger erzeugt wird. Die Detektionseinrichtung 6 kann in Alternative auch derart ausgelegt sein, dass der Wafer 10 als Reflektor dient, der das Licht bzw. die Strahlung vom Sender auf den Empfänger reflektiert, außer die Randkerbe 90 erreicht den Strahlengang des Senders, wodurch der Strahl durch die Randkerbe 90 hindurchgeht und nicht am Wafer reflektiert wird und der Empfänger folglich keinen reflektierten Strahl mehr empfängt und ein entsprechendes Detektionssignal erzeugt. Die Erzeugung und Ausgabe des Detektionssignals bedeutet also, dass der Wafer 10 eine vorgesehene Position bzw. Waf□rreferenzposition erreicht hat.

Die Steuereinrichtung der Vorrichtung der Erfindung ist z.B. ein programmgesteuerter Mikrocomputer oder Mikrocontroller, der elektrisch über entsprechende Kabelverbindungen und Schnittstellen mit dem elektromotorischen Drehtellerantrieb des Drehtellers 1.1, dem elektromotorischen Hubantrieb der Hebeeinrichtung 5.1 und mit der Wegmesseinrichtung verbunden ist, um die Drehung des Drehtellers 1.1 über den zugehörigen Drehtellerantrieb und die lineare Hubbewegung der Hebeeinrichtung 5.1 über den zugehörigen Hubantrieb in Abhängigkeit von bzw. Antwort auf die Detektionssignale von der Detektionseinrichtung 6 und den von der Wegmesseinrichtung ermittelten, zurückgelegten Weg bzw. der Momentanwinkelposition des Drehtellers 1.1 steuern zu können. Die Steuereinrichtung ermittelt auch mittels der Versatzdetektionseinrichtung 9 den Waferversatz. Von der Steuereinrichtung werden nicht nur sämtliche Einrichtungen der Bearbeitungsvorrichtung der Erfindung und der Ausrichtvorrichtung sondern auch sämtliche Verfahrensschritte des Ausrichtverfahrens und des Versatzermittlungsverfahrens der Erfindung gesteuert.

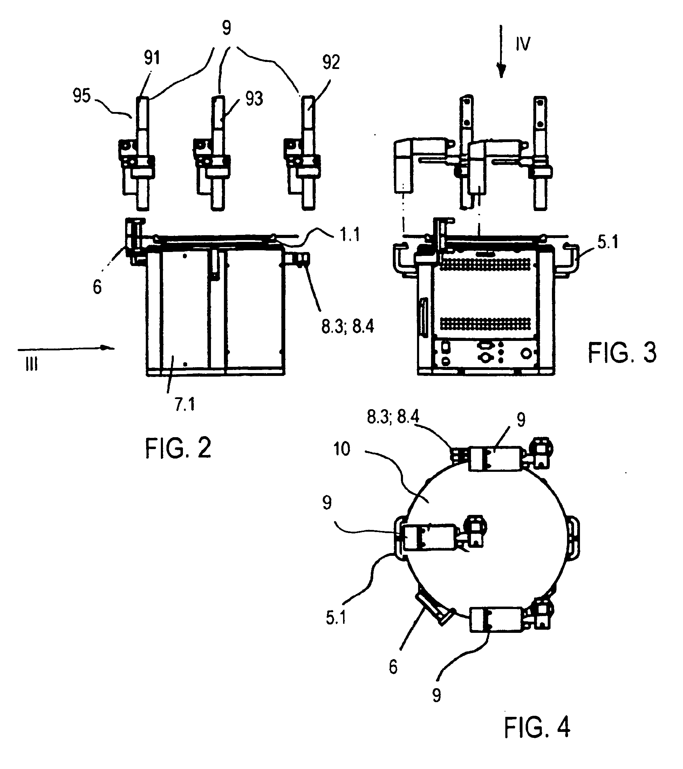

Die in Fig. 1, Fig. 2, Fig. 3 und Fig. 4 gezeigte Ausführungsform der Ausrichtvorrichtung der Erfindung ist in den gezeigten Ansichten mit einem auf dem Drehteller 1.1 aufliegenden Wafer 10 gezeigt, der z.B. einen Durchmesser von 300 mm haben kann und ein Siliziumwafer sein kann.

Die Versatzdetektionseinrichtung 9 der Erfindung wird zum Detektieren und Erkennen eines Versatzes des auf dem Drehteller 1.1 aufliegenden Wafers 10 gegenüber einer vorgegebenen Referenzposition oder Sollposition eines Wafers verwendet, wobei als Versatz die Differenz bzw. die Unterschiede zwischen der Istposition eines zu bearbeitenden Wafers und der vorgegebenen Sollposition des Wafers 10 betrachtet wird. Aus diesen Unterschieden ermittelt die Versatzdetektionseinrichtung 9 z.B. kartesische Versatzkoordinaten (xᵥ,yᵥ) einer horizontalen Ebene, die der obenliegenden Seite des Wafers 10 entspricht bzw. zu dieser zumindest parallel ist.

In der gezeigten beispielhaften und bevorzugten Ausführungsform von Fig. 1 hat die Versatzdetektionseinrichtung 9 eine erste Kameraeinrichtung 91, eine zweite Kameraeinrichtung 92 und eine dritte Kameraeinrichtung 93, die baugleich sind.

Die Kameraeinrichtungen 91, 92 und 93 haben jeweils z.B. ein Objektiv 97 und eine elektrische CCD-Einrichtung (CCD = Charge Coupled Device) 94 zum Aufnehmen eines Bilds oder Teilbilds des Wafers 10, eine Lichtquelle 98 zum Bestrahlen zumindest eines Teils des Wafers 10 und eine Halterung 95, mit der die Objektiv-CCD-Einheit der jeweiligen Kameraeinrichtung an einem Rahmen oder Gehäuse einer Waferbearbeitungsvorrichtung angebracht ist. Jede der Kameraeinrichtungen 91, 92, 93 kann einen Umlenkspiegel 99 zum Umlenken der Lichtstrahlen vom Objektiv 97 auf die CCD-Einrichtung 94 haben, um eine platzsparende Bauweise der Kameraeinrichtungen 91, 92, 93 ermöglichen zu können.

Die CCD-Einrichtung 94 kann z.B. einen zweidimensionalen, also flächigen, CCD-Chip oder eine eindimensionale CCD-Zeile haben. Vor dem Objektiv 97 ist bevorzugt ein optisches Filter 100 in jeder Kameraeinrichtung 91, 92, 93 angeordnet, das einen bestimmten, ausgewählten Lichtwellenlängenbereich des einfallenden Lichts durchlässt. Bevorzugt ist ein Infrarot-Filter als optischer Filter 100 vorgesehen, der nur infrarotes Licht durchlässt und somit andere, unerwünschte Lichtbestandteile abblockt, z.B. Streulicht von außen, die ansonsten die Detektion stören oder verfälschen könnten.

Die Lichtquelle 98, die bei auf dem Drehteller aufliegendem Wafer 10 unter dem Wafer 10 angeordnet ist, hat bevorzugt eine Infrarotlichtquelle, die z.B. eine Lumineszenzdiode oder mehrere Lumineszenzdioden aufweist, die Licht im Infrarotbereich abgibt bzw. abgeben, und einen Diffusor, auf den das Infrarotlicht gestrahlt wird und der ein diffuses Licht mit gleichmä-βiger Lichtverteilung erzeugt, das auf den Wafer 10, insbesondere auf seinen Randbereich, strahlt. Der Diffusor kann eine transparente, weiße bzw. milchige Plexiglasscheibe oder mehreren solche hintereinander im Strahlengang angeordnete Plexiglasscheiben aufweisen.

Die Bearbeitung des Wafers kann z.B. ein Markieren oder Beschreiben des Wafers mit einem Laserstrahl, das Lesen einer auf dem Wafer vorhandenen Markierung oder das Schneiden oder Anritzen des Wafers mit einem Laserstrahl sein. Um die Bearbeitung des Wafers mit der geforderten hohen Genauigkeit auch Durchführen zu können, wird ein Korrektursignal oder werden Korrekturinformationen oder -daten erzeugt, die ein Maß für den Unterschied zwischen der Soll-Bearbeitungsposition oder einer Referenzbearbeitungsposition des Wafers und einer Ist-Bearbeitungsposition oder tatsächlichen Bearbeitungsposition des Wafers auf dem Drehteller 1 wiedergibt.

Nachfolgend wird die Erzeugung eines Korrektursignals bzw. Versatzsignals mittels der ersten Kameraeinrichtung 91 der Einrichtung 9 erläutert, wobei davon ausgegangen wird, dass die Ausrichtvorrichtung 40 unter Verwendung des Drehtellers 1.1 und der Hebeeinrichtung 5.1 einen zu bearbeitenden Wafer in die Bearbeitungsposition bringt bzw. ausrichtet, die nachfolgend auch als Ist-Bbearbeitungsposition des zu bearbeitenden Wafers bezeichnet wird.

Beim Einjustieren der ersten Kameraeinrichtung 91 wird von einem auf dem Drehteller 1 aufliegenden Musterwafer bzw. Referenzwafer, der genau in der vorgegebenen Bearbeitungsposition angeordnet worden ist, ein digitales Referenzbild mit der CCD-Einrichtung 94 der Kameraeinrichtung 91 aufgenommen, das in einem entsprechenden Referenzbildspeicher der Steuereinrichtung abgespeichert wird. Das Referenzbild gibt ein Abbild der Kerbe des Referenzwafers in der Referenzbearbeitungsposition bzw. Soll-Bearbeitungsposition wieder, auf die die Bearbeitung des Wafers abgestimmt bzw. eingestellt wird.

Vor der tatsächlichen Bearbeitung eines zu bearbeitenden Wafers, der bereits in die Bearbeitungsposition, also die Ist-Bearbeitungsposition auf dem Drehteller 1 gedreht worden ist, nimmt nun die Kameraeinrichtung 91 ein Ist-Bild des jeweils zu bearbeitenden Wafers in der erreichten Bearbeitungsposition auf. Dieses digitale Ist-Bild wird für den zu bearbeitenden Wafer in einem Ist-Bildspeicher, z.B. RAM, der Steuereinrichtung pixelweise als Bitinformationen abgespeichert und zeigt die Kerbe des zu bearbeitenden Wafers in der Ist-Bearbeitungsposition, die sich aufgrund eines Ausrichtfehlers in der Ausrichtvorrichtung durch die nicht zu vermeidenden Fertigungstoleranzen der Ausrichtvorrichtung und auch der Wafer selbst von der vorgegebenen Soll-Bearbeitungsposition unterscheidet.

Im Ist-Bildspeicher ist das Bild der Kerbe des zu bearbeitenden Wafers in der Ist-Bearbeitungsposition pixelweise nach Art einer Matrix mit Spalten und Zeilen in synchroner Anordnung zu dem Referenzbild der Kerbe des Referenzwafers im Referenzbildspeicher abgespeichert, um einen pixelweisen Vergleich von Referenzbild, also Soll-Bild, und Ist-Bild zu ermöglichen. In einem beispielhaften, einfachen Fall sind das Referenzbild und das Ist-Bild jeweils Schwarz/Weiß-Bilder, deren Pixel jeweils als ein Bit von Daten in den Bildspeichern mit Matrixordnung abgespeichert sind. Genauer ist z.B. einem Pixel mit der Eigenschaft Schwarz ein Bit mit dem Wert "1" zugeordnet, während einem Pixel mit der Eigenschaft "Weiß" ein Bit mit dem Wert "0" zugeordnet ist. Weiterhin wird vereinfacht ausgedrückt, die Eigenschaft "Schwarz" der Oberfläche des Wafers an der Kerbe zugeordnet, während die Eigenschaft "Weiß" dem Leerraum innerhalb der Kerbe zugeordnet wird. Betrachtet man nun z.B. eine Pixelzeile des Referenzbildes oder des Ist-Bildes, können allgemein gesagt bei einer Kerbe, die z.B. v-förmig zum Rand des Wafers hin geöffnet ist, ein oder zwei Übergänge zwischen "Schwarz" und "Weiß" bzw. umgekehrt von der Steuereinrichtung oder dem Videoprozessor gefunden werden, die als Kontrastübergänge an den Kanten der Kerbe des Wafers bezeichnet werden. Die Kontrastübergänge im Referenzbild und die Kontrastübergänge im jeweiligen Ist-Bild können nun von der Steuereinrichtung miteinander verglichen werden, um einen Versatz bzw. Versatzfehler zwischen dem Wafer in der Ist-Bearbeitungsposition und der Referenzbearbeitungsposition zu ermitteln.

An einem vereinfachten Beispiel soll das Auffinden dieses Versatzes durch die Steuereinrichtung nachfolgend veranschaulicht werden. Die Steuereinrichtung wertet das Referenzbild z.B. zeilenweise aus und sucht diejenige Zeile des Referenzbilds mit der minimalen Anzahl von weißen Pixel mit dem Bitwert "0". Nach Auffinden der Zeile mit der minimalen Anzahl der weißen Pixel, die idealerweise in einer Reihenfolge von einem oder mehreren weißen Pixel vorliegt, ermittelt die Steuereinrichtung dann das mittlere Pixel in der Mitte dieser aufgefundenen Reihenfolge und ordnet ihm die Eigenschaft bzw. das Merkmal "Referenz-Scheitelpixel" zu, die den Scheitelpunkt der v-förmigen Kerbe im Referenzbild angibt. Da sich dieses Referenz-Scheitelpixel in einer bestimmten Zeile und Spalte des Referenzbildes im Referenzbildspeicher befindet, kann die Steuereinrichtung diesem Referenz-Scheitelpixels auch eine bestimmte x,y-Koordinate zuordnen, z.B. (30,51). Die Steuereinrichtung wertet dann das Ist-Bild ähnlich zeilenweise aus und sucht darin diejenige Zeile des Ist-Bilds mit der minimalen Anzahl von weißen Pixel mit dem Bitwert "0". Nach dem Auffinden der Zeile mit der minimalen Anzahl der weißen Pixel, die idealerweise in einer Reihenfolge von einem oder mehreren wei-βen Pixel vorliegt, ermittelt dann die Steuereinrichtung das mittlere Pixel in der Mitte dieser aufgefundenen Reihenfolge und ordnet ihm die Eigenschaft "Ist-Scheitelpixel" zu, die den Scheitelpunkt der v-förmigen Kerbe im Ist-Bild angibt. Da sich dieses Ist-Scheitelpixel in einer bestimmten Zeile und Spalte des Ist-Bilds im Ist-Bildspeicher befindet, kann die Steuereinrichtung diesem Ist-Scheitelpixel auch eine bestimmte x,y-Koordinate zuordnen, z.B. (100,150). Aus der Differenz zwischen den Koordinaten von Referenz-Scheitelpixel und Ist-Scheitelpixel ermittelt die Steuereinrichtung dann die x,y-Versatzkoordinate, z.B. (100-30,150-51) = (70,99), die über den bekannten Abbildungsmaßstab von Pixel/mm in einen entsprechenden längenmäßigen Versatzwert in x-Richtung und y-Richtung von der Steuereinrichtung umgerechnet werden kann.

Die ermittelte Versatzkoordinate bzw. der ermittelte Versatz wird dann von der Steuereinrichtung der Ausrichtvorrichtung an die Bearbeitungsvorrichtung ausgegeben, die dann den Versatz bzw. die Versatzkoordinate bei der Bearbeitung des zu bearbeitenden Wafers berücksichtigt, um die Bearbeitung des Wafers mit der vorgesehenen Lagegenauigkeit durchführen zu können.

Als ein Beispiel einer Waferbearbeitung wird nun das Markieren bzw. das Beschreiben des Wafers mittels einem Laserstrahl in einer Markiervorrichtung erläutert, die die vorstehende Ausrichtvorrichtung der Erfindung verwendet und die genauer z.B. in der EP 1231627 A2 beschrieben wird, deren Inhalt hier durch Bezugnahme aufgenommen wird.

Die Markiervorrichtung hat im wesentlichen eine Lasereinrichtung, die einen Laserstrahl erzeugt, welcher über eine Laserstrahlablenkeinheit und eine Fokussiereinrichtung auf die Waferoberfläche gelenkt wird, um den Wafer an einer vorgesehenen Stelle zu markieren oder zu beschreiben. Als Laserstrahlablenkeinheit kann z.B. eine elektromotorisch angetriebene Galvanometerspiegeleinrichtung verwendet werden. Bei der Positionseinstellung der Laserstrahlablenkeinheit können nun der in der Ausrichtvorrichtung ermittelte Versatz oder die zugehörigen Versatzkoordinaten berücksichtigt werden, um einen Ausrichtfehler des Wafers auf dem Drehteller 1 der Ausrichtvorrichtung kompensieren zu können, wodurch eine hochgenaue Bearbeitung bzw. Markierung des Wafers ermöglicht wird.

Nachfolgend wird die Verwendung der zweiten, optionalen Kameraeinrichtung 92 erläutert, die genau gegenüberliegend im Bereich des Randes eines auf dem Drehteller 1 aufliegenden Wafers 10 angeordnet ist, also um 180 ° versetzt zur ersten Kameraeinrichtung 91, um einen Wafer, falls erforderlich, auch gegenüberliegend zur Kerbe bearbeiten zu können. Nachdem der Wafer mit seiner Kerbe oder Markierung in die Bearbeitungslage unter die erste Kameraeinrichtung 91 gedreht worden ist, wird der Drehteller 1 von der Steuereinrichtung der Ausrichtvorrichtung derart angesteuert, dass der Drehteller um weitere 180 ° gedreht wird, was von der Steuereinrichtung über die Wegmesseinrichtung überprüft wird. Der Wafer befindet sich nach der 180 ° Drehung dann mit seiner Kerbe im Erfassungsbereich der zweiten Kameraeinrichtung 92, die dann ein Ist-Bild der Kerbe des zu bearbeitenden, aktuellen Wafers aufnimmt und an die Steuereinrichtung der Ausrichtvorrichtung ausgibt, wo die Daten des Ist-Bilds, wie vorstehend im Zusammenhang mit der ersten Kameraeinrichtung 91 erläutert wurde, in dem Ist-Bildspeicher abgespeichert werden. Dieses Ist-Bild wird dann von der Steuereinrichtung mit einem vorher aufgenommenen Referenzbild der Kerbe eines einjustierten Musterwafers unter der zweiten Kameraeinrichtung 92 verglichen, um eine Versatzkoordinate oder einen Versatz für die Bearbeitung des Wafers durch eine Bearbeitungsvorrichtung zu ermitteln. Das Verfahren zum Ermitteln des Versatzes ist das gleich, wie es mit Bezug auf die erste Kameraeinrichtung 91 vorstehend erläutert wurde. Der Versatz wird dann von der Bearbeitungsvorrichtung wieder dazu verwendet, einen Ausrichtfehler zu kompensieren. Mit Hinsicht auf die vorstehend erwähnte Markiervorrichtung bedeutet dies, dass der Versatz, der mit Hilfe der zweiten Kameraeinrichtung 92 ermittelt wurde, beim Ablenken des Laserstrahls zum Markieren der Oberfläche des Wafers im Bereich benachbart zur ersten Kameraeinrichtung 91 verwendet wird.

Nachfolgend wird die Erzeugung eines Korrektursignals mittels der dritten Kameraeinrichtung 93 der Einrichtung 9 erläutert. Die dritte Kameraeinrichtung 93 ist um 90 ° versetzt zur ersten Kameraeinrichtung 91 und auch zur zweiten Kameraeinrichtung 92 am Drehkreis des Drehtellers, d.h. über dem Waferrand, angeordnet.

Beim Einjustieren der dritten Kameraeinrichtung 93 wird von einem auf dem Drehteller 1 aufliegenden Musterwafer bzw. Referenzwafer, der genau in der vorgegebenen Bearbeitungsposition angeordnet worden ist, ein digitales Referenzbild mit der CCD-Einrichtung 94 der Kameraeinrichtung 93 aufgenommen, das in einem entsprechenden, dritten Referenzbildspeicher der Steuereinrichtung abgespeichert wird. Das Referenzbild gibt ein Abbild des Rands des Referenzwafers senkrecht von oben gesehen in der Referenzbearbeitungsposition bzw. Soll-Bearbeitungsposition wieder, auf die die Bearbeitung des Wafers abgestimmt bzw. eingestellt wird.

Vor der tatsächlichen Bearbeitung eines zu bearbeitenden Wafers, der bereits in die Bearbeitungsposition, also die Ist-Bearbeitungsposition, auf dem Drehteller 1 gedreht worden ist, nimmt nun die Kameraeinrichtung 93 ein Ist-Bild des jeweils zu bearbeitenden Wafers in der erreichten Bearbeitungsposition auf. Dieses digitale Ist-Bild wird für den zu bearbeitenden Wafer in einem dritten Ist-Bildspeicher der Steuereinrichtung pixelweise als Bitinformationen abgespeichert und zeigt einen Teil des Rands bzw. der Kante des zu bearbeitenden Wafers in der Ist-Bearbeitungsposition, die sich aufgrund eines Ausrichtfehlers in der Ausrichtvorrichtung durch die nicht zu vermeidenden Fertigungstoleranzen der Ausrichtvorrichtung und auch der Wafer selbst von der vorgegebenen Soll-Bearbeitungsposition unterscheidet.

Im dritten Ist-Bildspeicher ist das Bild des Abschnitts des Waferrands des zu bearbeitenden Wafers in der Ist-Bearbeitungsposition pixelweise nach Art einer Matrix mit Spalten und Zeilen in synchroner Anordnung zu dem Referenzbild des entsprechenden Abschnitts des Waferrands des Referenzwafers im Referenzbildspeicher abgespeichert, um einen pixelweisen Vergleich von Referenzbild, also Soll-Bild, und Ist-Bild zu ermöglichen. In einem beispielhaften, einfachen Fall sind das Referenzbild und das Ist-Bild jeweils Schwarz/Weiß-Bilder, deren Pixel jeweils als ein Bit von Daten in den Bildspeichern mit Matrixordnung abgespeichert sind. Genauer ist auch hier z.B. einem Pixel mit der Eigenschaft Schwarz ein Bit mit dem Wert "1" zugeordnet, während einem Pixel mit der Eigenschaft "Weiß" ein Bit mit dem Wert "0" zugeordnet ist. Weiterhin wird vereinfacht ausgedrückt, die Eigenschaft "Schwarz" der Oberfläche des Wafers an dem Rand bzw. Kante zugeordnet, während die Eigenschaft "Weiß" dem Leerraum neben der Kante des Wafers zugeordnet wird. Betrachtet man nun z.B. eine Pixelzeile, des Referenzbildes oder des Ist-Bildes kann allgemein gesagt bei einem Rand ein Übergang zwischen "Schwarz" und "Weiß" bzw. umgekehrt von der Steuereinrichtung oder dem Videoprozessor gefunden werden, der als Kontrastübergang an der Waferkante bezeichnet wird. Der Kontrastübergang im Referenzbild und der Kontrastübergang im jeweiligen Ist-Bild können nun von der Steuereinrichtung miteinander verglichen werden, um einen Versatz bzw. Versatzfehler zwischen dem Wafer in der Ist-Bearbeitungsposition und der Soll-Bearbeitungsposition zu ermitteln.

An einem vereinfachten Beispiel soll das Auffinden dieses Waferkantenversatzes durch die Steuereinrichtung nachfolgend veranschaulicht werden. Die Steuereinrichtung wertet das Referenzbild von der dritten Kameraeinrichtung 93 z.B. für eine vorgegebene Anzahl von Zeilen oder die Gesamtanzahl der Pixelzeilen zeilenweise aus und sucht in jeder Zeile das Pixel mit dem Bitwert "1", dem eine Pixel mit dem Bitwert "0" folgt oder dem nur noch Pixel mit dem Bitwert "0" folgen. Dieses Pixel "1" wird dann als "Übergangspixel" bzw. als Referenz-Waferkantenpixel bezeichnet, dem eine bestimmte x-Koordinate von der Steuereinrichtung zugeordnet werden kann, da es in einer bestimmten Zeile und Spalte des Referenzbildes im dritten Referenzbildspeicher befindet. Nach Durcharbeiten der vorgegebenen Anzahl von Zeilen liegt pro Zeile mit einem Übergang ein solches Übergangspixel mit jeweils einer entsprechenden x-Koordinate vor.

Die Steuereinrichtung wertet nun das Ist-Bild von der dritten Kameraeinrichtung 93 z.B. für die gleiche vorgegebene Anzahl von den gleichen, vorgegebenen Zeilen zeilenweise aus und sucht in jeder Zeile das Pixel mit dem Bitwert "1", dem eine Pixel mit dem Bitwert "0" folgt oder dem nur noch Pixel mit dem Bitwert "0" folgen. Dieses Pixel "1" wird dann als "Übergangspixel" bzw. als Ist-Waferkantenpixel bezeichnet, dem eine bestimmte x-Koordinate von der Steuereinrichtung zugeordnet werden kann, da es sich in einer bestimmten Zeile und Spalte des Ist-Bilds im dritten Ist-Bildspeicher befindet. Nach Durcharbeiten der vorgegebenen Anzahl von Zeilen liegt pro Zeile mit einem Übergang ein solches Übergangspixel mit jeweils einer x-Koordinate vor.

Aus der Differenz zwischen den x-Koordinaten von Referenz-Waferkantenpixel und Ist-Waferkantenpixel ermittelt die Steuereinrichtung dann die x-Versatzkoordinate, die über den bekannten Abbildungsmaßstab von Pixel/mm, z.B. 100 Pixel/mm, in einen entsprechenden längenmäßigen Versatzwert in x-Richtung von der Steuereinrichtung umgerechnet werden kann.

Diese ermittelte Kanten-Versatzkoordinate bzw, dieser ermittelte Kanten-Versatz wird dann von der Steuereinrichtung der Ausrichtvorrichtung an die Bearbeitungsvorrichtung ausgegeben, die dann den Versatz bzw. die Versatzkoordinate bei der Bearbeitung des zu bearbeitenden Wafers berücksichtigt, um die Bearbeitung des Wafers mit der vorgesehenen Lagegenauigkeit durchführen zu können.

Da die Ermittlung des Versatzes in x-Richtung an der Waferkante mittels der dritten Kameraeinrichtung 93 häufig genauer als die Ermittlung des Versatzes in x-Richtung an der Waferkerbe mittels der ersten Kamera 91 ist, kann die Bearbeitungsvorrichtung den mittels der dritten Kameraeinrichtung 93 ermittelten x-Versatz an der Waferkante vorrangig zur Korrektur der Bearbeitungseinstellung berücksichtigen.

Die dritte Kameraeinrichtung 93 kann in einer alternativen Ausführungsform auch entfallen, wenn mittels der ersten Kameraeinrichtung 91 zusätzlich zu dem Versatz an der Kerbe des Wafers auch der Versatz an der Kante des Wafers ermittelt wird. Hierbei wird zunächst mittels der Kameraeinrichtung 91 der Versatz an der Kerbe des Wafers ermittelt. Dann wird der Drehteller 1.1 mit Wafer genau um 90 ° derart gedreht, dass der entsprechende Kantenabschnitt des Wafers sich unter der (ersten) Kameraeinrichtung 91 befindet. Anschließend wird mittels der Kameraeinrichtung 91 der Versatz an diesem Kantenabschnitt des Wafers ermittelt und zur Korrektur des Ausrichtfehlers verwendet. Zur Bearbeitung des Wafers wird dann schließlich der Wafer wieder um 90 ° zurück in seine Bearbeitungsposition mit dem Drehteller 1.1 gedreht.

Nach der Bearbeitung des Wafers durch die Bearbeitungsvorrichtung wird dann allgemein der bearbeitete Wafer von einem Roboterarm mit Endeffektor, der seitlich ansetzt, wieder vom Drehteller 1.1 hochgehoben und aus der Ausrichtvorrichtung oder Bearbeitungsvorrichtung entfernt und z.B. in einer Waferkassette abgelegt, um die Bearbeitungsvorrichtung wieder bereit für die Bearbeitung eines weiteren Wafers zu machen.

## Patentansprüche

1. Vorrichtung zum Markieren oder Beschreiben eines wafers mit einem Laserstrahl, wobei die Vorrichtung eine Ausrichtvorrichtung (40) mit einem Drehteller (1.1) zum Ausrichten eines Wafers (10), der den Wafer (10) trägt und der um seine Drehachse (M) zum Ausrichten des Wafers (10) in eine Ist-Bearbeitungsposition drehbar ist, und eine Lasereinrichtung hat, die den Laserstrahl erzeugt, den eine Laserstrahlablenkeinheit und eine Fokussiereinrichtung der Lasereinrichtung auf die Waferoberfläche lenkt, um den wafer an einer vorgesehenen Stelle zu markieren oder zu beschreiben,
**dadurch gekennzeichnet,**
**dass** der Drehteller (1.1) derart ausgebildet ist, dass der Wafer (10) auf dem Drehteller (1.1) nur mit seinem Rand oder Randbereich aufliegt,
**dass** eine Versatzdetektionseinrichtung (9) vorgesehen ist, die einen Versatz oder zugehörige Versatzkoordinaten als ein Maß für einen Ausrichtfehler zwischen einer Soll-Bearbeitungsposition, in der ein Wafer (10) von der Lasereinrichtung markiert werden soll, und der tatsächlich durch die Ausrichtvorrichtung (40) erreichten Ist-Bearbeitungsposition des zu markierenden Wafers (10) mittels mindestens einer Kameraeinrichtung (91; 92; 93) zum Aufnehmen eines Bilds oder Teilbilds eines Wafers (10) ermittelt, und
**dass** die Laserstrahlablenkeinheit den ermittelten Versatz oder die zugehörigen Versatzkoordinaten zum Korrigieren oder Kompensieren des Ausrichtfehlers beim Markieren oder Beschreiben des Wafers verwendet.

2. Vorrichtung nach Anspruch 1, **dadurch gekennzeichnet, dass** die Versatzdetektonseinrichtung (9) eine erste Kameraeinrichtung (91) zum Ermitteln des Versatzes eines Wafers zu der vorgegebenen Soll-Bearbeitungsposition an einer Kerbe (90) eines Wafers hat.

3. Vorrichtung nach Anspruch 1 oder Anspruch 2, **dadurch gekennzeichnet, dass** die Versatzdetektionseinrichtung (9) eine weitere, zweite Kameraeinrichtung (93) zum Ermitteln des Versatzes eines Wafers zu einer vorgegebenen Soll-Bearbeitungsposition an einem Abschnitt des kreisförmigen Rands oder der Kante eines Wafers hat.

4. Vorrichtung nach Anspruch 3, **dadurch gekennzeichnet, dass** die weitere, zweite Kameraeinrichtung (93) um einen Winkel von 90 ° von der ersten Kameraeinrichtung (91) über dem Rand des Wafers versetzt angeordnet ist.

5. Vorrichtung nach einem der Ansprüche 1 bis 4, **gekennzeichnet durch** eine noch weitere, dritte Kameraeinrichtung (92) zum Ermitteln des Versatzes eines Wafers zu einer vorgegebenen Soll-Bearbeitungsposition an einer Kerbe (90) eines Wafers, wobei die noch weitere, dritte Kameraeinrichtung (92) um einen Winkel von 180 ° von der ersten Kameraeinrichtung (91) über dem Rand des Wafers versetzt angeordnet ist.

6. Vorrichtung nach einem der Ansprüche 1 bis 5, **dadurch gekennzeichnet, dass** die Kameraeinrichtung (91; 92; 93) eine CCD-Einrichtung (94) und ein Objektiv (97) hat, das auf die CCD-Einrichtung (94) abbildet.

7. Vorrichtung nach einem der Ansprüche 1 bis 6, **dadurch gekennzeichnet, dass** die Kameraeinrichtung (91; 92; 93) eingangsseitig einen Filter (100) hat, der einen bestimmten, ausgewählten Lichtwellenlängenbereich des einfallenden Lichts durchlässt.

8. vorrichtung nach Anspruch 7, **dadurch gekennzeichnet, dass** der Filter (100) ein Infrarot-Filter ist, der nur infrarotes Licht durchlässt.

9. Vorrichtung nach einem der Ansprüche 1 bis 8, **gekennzeichnet durch** eine Lichtquelle (98) zum Bestrahlen mindestens eines Teils eines Wafers (10), wobei die Lichtquelle (98) bevorzugt eine Infrarotlichtquelle ist, die Licht oder elektromagnetische Strahlung im Infrarotbereich abgibt.

10. Vorrichtung nach dem Anspruch 9, **dadurch gekennzeichnet, dass** die Lichtquelle (98) einen ausgangsseitigen Diffusor für die gleichmäßige Lichtverteilung hat.

11. Vorrichtung nach einem der vorstehenden Ansprüche, **dadurch gekennzeichnet, dass** die Ausrichtvorrichtung eine Einrichtung zum Halten des Wafers (10) in einer Lage mit Abstand von dem Drehteller (1.1) derart aufweist, dass sich der Drehteller (1.1) ohne den Wafer (10) drehen kann.

12. Verfahren zum Markieren oder Beschreiben eines Wafers mit einem Laserstrahl, bei dem der Wafer von einem Drehteller (1.1) einer Ausrichtvorrichtung (40) getragen wird und der Wafer auf dem Drehteller (1.1) zum Ausrichten des Wafers in eine Ist-Bearbeitungsposition um eine Drehachse (M) des Drehtellers (1.1) gedreht wird, wobei
ein Wafer (10) von dem Drehteller (1.1) nur an einem Rand oder Randbereich des Wafers getragen wird;
wobei mit einer Kameraeinrichtung (91) einer Versatzdetektionseinrichtung (9) von einem auf einem Drehteller (1.1) der Ausrichtvorrichtung (40) aufliegenden Musterwafer oder Referenzwafer, der genau in einer vorgegebenen Soll-Bearbeitungsposition angeordnet worden ist, ein digitales Referenzbild als Soll-Bild aufgenommen wird, das in einem entsprechenden Soll-Bildspeicher abgespeichert wird;
wobei vor der tatsächlichen Bearbeitung eines zu markierenden oder zu beschreibenden Wafers, der bereits in die Ist-Bearbeitungsposition auf dem Drehteller (1.1) gedreht worden ist, von der Kameraeinrichtung (91) der Versatzdetektionseinrichtung-(9) ein Ist-Bild des Wafers in der erreichten Ist-Bearbeitungsposition aufgenommen wird;
wobei das Soll-Bild und das Ist-Bild von der Versatzdetektionseinrichtung (9) miteinander verglichen werden, um einen Versatz oder zugehörige Versatzkoordinaten als ein Maß für einen Ausrichtfehler zwischen der. Soll-Bearbeitungsposition, in der der Wafer bearbeitet werden soll, und der tatsächlichen Ist-Bearbeitungsposition des Wafers in der Ausrichtvorrichtung (40) zu ermitteln, wobei der ermittelte Versatz oder die zugehörigen Versatzkoordinaten von einer Laserstrahlablenkeinheit zum Korrigieren oder Kompensieren des Ausrichtfehlers des Wafers beim Markieren oder Beschreiben des Wafers mittels Laserstrahl verwendet wird oder werden.

13. Verfahren nach Anspruch 12, **dadurch gekennzeichnet, dass** das Referenzbild oder Soll-Bild zumindest einen Teil der Kerbe des Referenzwafers in der Soll-Bearbeitungsposition wiedergibt.

14. Verfahren nach Anspruch 13, **dadurch gekennzeichnet, dass** das digitale Ist-Bild des zu markierenden oder zu beschreibenden Wafers in einem Ist-Bildspeicher abgespeichert wird.

15. Verfahren nach Anspruch 13 oder Anspruch 14, **dadurch gekennzeichnet, dass** das Ist-Bild des zu markierenden oder zu beschreibenden Wafers zumindest einen Teil einer Kerbe (90) des Wafers (10) in der Ist-Bearbeitungsposition wiedergibt.

16. Verfahren nach einem der Ansprüche 12 bis 15, **dadurch gekennzeichnet, dass** im Referenzbild oder Soll-Bild ein vorgegebenes Merkmal gesucht wird und nach Auffinden des Merkmals zugehörige Soll-Koordinaten ermittelt werden,
dass im Ist-Bild eines zu markierenden oder zu beschreibenden Wafers das vorgegebene Merkmal gesucht wird und nach Auffinden des Merkmals zugehörige Ist-Koordinaten ermittelt werden, und dass der Versatz in Abhängigkeit von den Soll-Koordinaten und den Ist-Koordinaten ermittelt wird.

17. Verfahren nach Anspruch 16, **dadurch gekennzeichnet, dass** als Merkmal der Scheitel oder Scheitelpunkt einer Kerbe (90) des Wafers (10) verwendet wird.

18. Verfahren nach Anspruch 16, **dadurch gekennzeichnet, dass** als Merkmal eine Kante oder Flanke der Kerbe (90) des Wafers (10) verwendet wird.

19. Verfahren nach Anspruch 16 **dadurch gekennzeichnet, dass** als Merkmal ein Rand- oder Kantenabschnitt des Wafers (10) verwendet wird.

20. Verfahren nach einem der Ansprüche 12 bis 19, **dadurch gekennzeichnet, dass** ein Kontrastübergang oder Helligkeitsübergang im Soll-Bild oder im Ist-Bild verwendet wird, um das vorgegebene Merkmal zu finden.

## Claims

1. Apparatus for marking and writing on a wafer using a laser beam, the apparatus having aligning means (40) having a rotary chuck (1.1) for aligning wafers (10), which supports the wafer (10) and which is rotateable about its rotary axis (M) into an actual working position to align the wafer (10), and laser means for generating the laser beam being directed by a laser beam deflection unit and focusing means of the laser means onto the surface of the wafer to mark or write on the wafer on a designated location,
**characterized in**
**that** the rotary chuck (1.1) is formed such that the wafer (10) lies on the rotary chuck (1.1) only with its edge or marginal area,
**that** offset detecting means (9) is provided which determines an offset or offset coordinates as a measure of an alignment error between a desired working position in which a wafer should be marked by the laser means and the actual working position of the wafer to be marked which is actually reached by the aligning means (40) by at least one camera means (91; 92; 93) for recording an image or divisional image of a wafer (10), and
**that** the laser beam deflecting unit uses the offset or offset coordinates being determined for correcting or compensating of the alignment error during marking and writing on the wafer.

2. Apparatus according to claim 1, **characterized in that** the offset detecting means (9) has a first camera means (91) for determining, at a notch (90) of the wafer, the offset of a wafer from a predetermined desired working position.

3. Apparatus according to claim 1 and claim 2, charactzerized in that the offset detecting means (9) has a second camera means (93) for determining, on a portion of the circular margin or edge of a wafer, the offset of a wafer from a predetermined desired working position.

4. Apparatus according to claim 3, **characterized in that** the further second camera means (93) is offset by an angle of 90° from the first camera means (91) above the edge of the wafer.

5. Apparatus according to one of the claims 1 to 4, **characterized by** a yet further third camera means (92) for determining, at a notch (90) of a wafer, the offset of the wafer from a predetermined desired working position, wherein the yet further, third camera means (92) is offset by an angle of 180° from the first camera means (91) above the edge of the wafer.

6. Apparatus according to one of the claims 1 to 5, **characterized in that** the camera means (91; 92; 93) has CCD means (94) and a lens (97) that images onto the CCD means.

7. Apparatus according to one of the claims 1 to 6, **characterized in that** the camera means (91; 92; 93) has a filter at its input side, which passes a specified, selected light wavelength range of the impinging light.

8. Apparatus according to claim 7, **characterized in that** the filter (100) is an infrared filter that passes only infrared light.

9. Apparatus according one of the claims 1 to 8, **characterized by** a light source (98) for irradiating of at least a part of a wafer (10) wherein the light source (98) is preferably an infrared light source that outputs electromagnetic radiation in the infrared range.

10. Apparatus according to claim 9, **characterized in that** the light source (98) has a diffuser for uniform distribution on its output side.

11. Apparatus according to one of the preceding claims, **characterized in that** the aligning means comprises means for holding a wafer (10) in a position spaced from the rotary chuck (1.1) such that the rotary chuck (1.1) is able to rotate without the wafer (10).

12. Method for marking and writing on a wafer using a laser beam wherein the wafer is supported by a rotary chuck (1.1) and wherein the wafer on the rotary chuck (1.1) is rotated about a rotary axis (M) of the rotary disc (1.1) into an actual working position for aligning the wafer,
wherein a wafer (10) is supported by the rotary chuck (1.1) only on an edge or edge area of the wafer;
wherein a digital reference image as a desired image is detected by camera means (91) of an offset detecting means (9) from a selected wafer or reference wafer lying on the rotary chuck (1.1) of the aligning means (40) and being arranged accurately in a predetermined desired working position, the desired image being stored in an assigned image memory of desired image;
wherein, before the actual working of the wafer to be marked and written on which has already been rotated into the actual working position on the rotary chuck (1.1), an actual image of the wafer in the reached actual working position is detected by the camera means (91) of the offset detecting means (9);
wherein the desired image and the actual image are compared with each other by the offset detecting means (9) to determine an offset or offset coordinates as a measure of an aligning error between the desired working position in which the wafer should be worked on, and the actual working position in the aligning means (40), the determined offset or the corresponding offset coordinates being used by a laser beam deflecting unit for correcting or compensating of the aligning error of the wafer during marking or writing on the wafer by a laser beam.

13. Method according to claim 12, **characterized in that** the reference image or desired image represents at least a part of the notch of the reference wafer in the desired working position.

14. Method according to claim 13, **characterized in that** the digital desired image of the wafer to be marked or written on is stored in a desired image memory.

15. Method according to claim 13 or claim 14, **characterized in that** the actual image of the wafer to be marked and written on represents at least a part of a notch (90) of the wafer (10) in the actual working position.

16. Method according to claim 12, **characterized in that** a predetermined feature is searched for in the reference image or desired image and corresponding desired coordinates are determined after finding the feature,
that the predetermined feature is searched for in the actual image of a wafer to be marked or written on and corresponding actual coordinates are determined after finding the feature, and
that the offset is determined on the basis of the desired coordinates and actual coordinates.

17. Method according to claim 16, **characterized in that** an apex or vertex of a notch (90) of the wafer (10) is used as the feature.

18. Method according to claim 16, **characterized in that** an edge or flank of a notch (90) of the wafer (10) is used as the feature.

19. Method according to claim 16, **characterized in that** a portion of an edge or a portion of a rim of the wafer (10) is used as the feature.

20. Method according to one of the claims 12 to 19, **characterized in that** a transition in contrast or a transition in brightness in the desired image or in the actual image is used to find the predetermined feature.

## Revendications

1. Dispositif pour appliquer une marque ou une inscription sur une plaquette à l'aide d'un rayon laser, le dispositif possédant un dispositif d'orientation (40) comportant un plateau-revolver (1.1) pour l'orientation d'une plaquette (10), qui porte la plaquette (10) et qui est rotatif autour de son axe de rotation (M), pour l'orientation de la plaquette (10) dans une position de traitement réelle, et un dispositif à laser qui génère le rayon laser, qui dirige une unité de déviation de rayon laser et un mécanisme de focalisation du dispositif à laser sur la surface de la plaquette pour appliquer une marque ou une inscription sur la plaquette à un endroit prévu,
**caractérisé**
**en ce que** le plateau-revolver (1.1) est réalisé de telle sorte que la plaquette (10) vient se disposer sur le plateau-revolver (1.1) uniquement avec son bord ou avec sa zone marginale ;
**en ce qu'**on prévoit un dispositif de détection de décalage (9) qui détermine un décalage ou des coordonnées de décalage correspondantes comme mesure pour une erreur d'orientation entre une position de traitement de consigne dans laquelle le dispositif à laser doit appliquer une marque sur une plaquette (10) et la position de traitement réelle, obtenue en réalité à l'aide du dispositif d'orientation (40), de la plaquette (10) qui doit être marquée, au moyen d'au moins un mécanisme à caméra (91 ; 92 ; 93) pour enregistrer une image ou une image partielle d'une plaquette (10) ; et
**en ce que** l'unité de déviation du rayon laser utilise le décalage déterminé ou les coordonnées de décalage correspondantes pour corriger ou pour compenser l'erreur d'orientation lors de l'application de la marque ou de l'inscription sur la plaquette.

2. Dispositif selon la revendication 1, **caractérisé en ce que** le dispositif de détection de décalage (9) possède un premier mécanisme à caméra (91) pour la détermination du décalage d'une plaquette par rapport à la position de traitement de consigne préétablie, à une encoche (90) d'une plaquette.

3. Dispositif selon la revendication 1 ou 2, **caractérisé en ce que** le dispositif de détection de décalage (9) possède un deuxième mécanisme à caméra supplémentaire (93) pour déterminer le décalage d'une plaquette par rapport à une position de traitement de consigne prédéfinie à un tronçon du bord circulaire ou de l'arête d'une plaquette.

4. Dispositif selon la revendication 3, **caractérisé en ce que** le deuxième mécanisme à caméra supplémentaire (93) est disposé en étant décalé d'un angle de 90° par rapport au premier mécanisme à caméra (91), autour du bord de la plaquette.

5. Dispositif selon l'une quelconque revendication 1 à 4, **caractérisé par** un troisième mécanisme à caméra supplémentaire encore (92) pour la détermination du décalage d'une plaquette par rapport à une position de traitement de consigne préétablie, à une encoche (90) d'une plaquette, le troisième mécanisme à caméra supplémentaire encore (92) étant disposé en étant décalé d'un angle de 180° par rapport au premier mécanisme à caméra (91), autour du bord de la plaquette.

6. Dispositif selon l'une quelconque des revendications 1 à 5, **caractérisé en ce que** le mécanisme à caméra (91 ; 92 ; 93) possède un dispositif CCD (94) et un objectif (97) qui procède à des reproductions sur le dispositif CCD (94).

7. Dispositif selon l'une quelconque des revendications 1 à 6, **caractérisé en ce que** le mécanisme à caméra (91 ; 92 ; 93) possède un filtre (100), côté entrée, qui laisse passer une gamme déterminée de longueurs d'ondes lumineuses sélectionnées de la lumière incidente.

8. Dispositif selon la revendication 7, **caractérisé en ce que** le filtre (100) est un filtre infrarouge qui ne laisse passer que la lumière infrarouge.

9. Dispositif selon l'une quelconque des revendications 1 à 8, **caractérisé par** une source lumineuse (98) pour l'éclairage d'au moins une partie d'une plaquette (10), la source lumineuse (98) étant de préférence une source de lumière infrarouge qui transmet de la lumière ou un rayonnement électromagnétique dans le domaine infrarouge.

10. Dispositif selon la revendication 9, **caractérisé en ce que** la source lumineuse (98) possède un diffuseur, côté sortie, pour la distribution uniforme de la lumière.

11. Dispositif selon l'une quelconque des revendications précédentes, **caractérisé en ce que** le dispositif d'orientation présente un mécanisme pour le maintien de la plaquette (10) dans une position à l'écart du plateau-revolver (1.1) de telle sorte que le plateau-revolver (1.1) peut tourner sans la plaquette (10).

12. Procédé pour appliquer une marque ou une inscription sur une plaquette à l'aide d'un rayon laser, dans lequel la plaquette est supportée par un plateau-revolver (1.1) d'un dispositif d'orientation (40) et la plaquette est mise en rotation sur le plateau-revolver (1.1), pour orienter la plaquette dans une position de traitement de consigne, autour d'un axe de rotation (M) du plateau-revolver (1.1),
dans lequel une plaquette (10) est supportée par le plateau-revolver (1.1) uniquement avec un bord ou avec la zone marginale de la plaquette ;
dans lequel, à l'aide d'un mécanisme à caméra (91) d'un dispositif de détection de décalage (9) d'une plaquette modèle ou d'une plaquette de référence disposée sur un plateau-revolver (1.1) du dispositif d'orientation (40), la plaquette en question ayant été placée de manière précise dans une position de traitement réelle prédéfinie, une image numérique de référence est enregistrée à titre d'image de consigne qui est mémorisée dans une mémoire d'image de consigne correspondante ;
dans lequel, avant le traitement proprement dit d'une plaquette sur laquelle il y a lieu d'appliquer une marque ou une inscription, qui a déjà été mise en rotation pour prendre la position de traitement de consigne sur le plateau-revolver (1.1), une image réelle de la plaquette dans la position de traitement réelle obtenue est enregistrée par le mécanisme à caméra (91) du dispositif de détection de décalage (9) ;
dans lequel l'image de consigne et l'image réelle sont comparées l'une à l'autre par le dispositif de détection de décalage (9) afin de déterminer un décalage ou des coordonnées de décalage correspondantes comme mesure pour une erreur d'orientation entre la position de traitement de consigne dans laquelle il y a lieu de traiter la plaquette et la position de traitement réelle de la plaquette dans le dispositif d'orientation (40), le décalage déterminé ou bien les coordonnées de décalage correspondantes étant utilisé(es) par une unité de déviation du rayon laser pour la correction ou la compensation de l'erreur d'orientation de la plaquette lors de l'application d'une marque ou d'une inscription sur la plaquette au moyen d'un rayon laser.

13. Procédé selon la revendication 12, **caractérisé en ce que** l'image de référence ou l'image de consigne représente au moins une partie de l'encoche de la plaquette de référence dans la position de traitement de consigne.

14. Procédé selon la revendication 13, **caractérisé en ce que** l'image réelle numérique de la plaquette sur laquelle il y a lieu d'appliquer une marque ou une inscription, est mémorisée dans une mémoire d'image réelle.

15. Procédé selon la revendication 13 ou 14, **caractérisé en ce que** l'image réelle de la plaquette sur laquelle il y a lieu d'appliquer une marque ou une inscription, représente au moins une partie d'une encoche (90) de la plaquette (10) dans la position de traitement réelle.

16. Procédé selon l'une quelconque des revendications 12 à 15, **caractérisé en ce que**, dans l'image de référence ou dans l'image de consigne, on cherche une caractéristique prédéfinie, et après la découverte de la caractéristique, on détermine des coordonnées de consigne correspondantes ;
**en ce que**, dans l'image réelle d'une plaquette sur laquelle il y a lieu d'appliquer une marque ou une inscription, on recherche la caractéristique prédéfinie et après avoir découvert la caractéristique, on détermine des coordonnées réelles correspondantes ; et **en ce que** le décalage est déterminé en fonction des coordonnées de consigne et des coordonnées réelles.

17. Procédé selon la revendication 16, **caractérisé en ce qu'**on utilise, comme caractéristique, le sommet ou le point culminant d'une encoche (90) de la plaquette (10).

18. Procédé selon la revendication 16, **caractérisé en ce qu'**on utilise, comme caractéristique, une arête ou un flanc de l'encoche (90) de la plaquette (10).

19. Procédé selon la revendication 16, **caractérisé en ce qu'**on utilise, comme caractéristique, un tronçon de bord ou d'arête de la plaquette (10).

20. Procédé selon l'une quelconque des revendications 12 à 19, **caractérisé en ce qu'**on utilise une transition de contraste ou une transition de clarté dans l'image de consigne ou dans l'image réelle, pour trouver la caractéristique prédéfinie.
